# EUROPEAN PATENT APPLICATION

(11) **EP 4 447 623 A1**
(43) Date of publication of application: **16.10.2024**
(21) Application number: 23167739.4
(22) Date of filing: 13.04.2023
(51) Int. Cl.: H05K 1/14, H05K 3/34, H05K 3/40, H05K 3/36

(54) **PRINTED CIRCUIT BOARD AND MANUFACTURING METHOD**

(71) Applicant: u-blox AG, 8800 Thalwil (CH)
(72) Inventor: Gergis, Anthony, 8800 Thalwil (CH); Saarnimo, Timo, 8800 Thalwil (CH)
(74) Representative: Epping - Hermann - Fischer

(57) **Abstract**

A printed circuit board (100), PCB, comprises a top surface (101), a bottom surface (107), a series of M castellated orifices (102) on at least one of the edges of the PCB, and a series of N conductive pads (103) on the top surface (101) connecting to the M orifices (102) at respective connection edges (104), wherein M and N are integers greater than 1. Each of the pads (103) on the top surface (101) is partially covered by a respective spacer (105) such that an area between the connection edge (104) and a border (106) of a remaining pad area (103') is completely covered by the spacer (105), and the connection edge (104) and the border (106) of the remaining pad area (103') have a minimum distance of D, wherein D is a positive number. A solder leaking is prevented between the pads (103) on the top surface (101) and the castellated orifices (102) by the spacers (105).

## Description

### TECHNICAL FIELD

This disclosure relates to a printed circuit board and a manufacturing method.

### BACKGROUND ART

In electronics and electrical engineering industry, printed circuit boards, PCBs, are widely used in various kinds of electronical devices. A PCB provides layers and connectivity for assembling integrated circuits and other electronic components. The circuits and electronic components on a single PCB may perform an integrated functionality and can be used as a single module, e.g. a wireless connectivity module. A single module can be further assembled on a motherboard, e.g. a system board, to provide its functionality and connect with other modules within a system.

When mounting a PCB on a motherboard, conductive pads around the edges of the PCB are typically soldered with pads on the motherboard. In some applications, pads may be in a land grid array, LGA, form and only exposed on the surfaces of a PCB. For example, the pads on the bottom surface of a PCB are soldered with the pads on the top surface of a motherboard, so that the PCB is conductively connected with the motherboard. Differently, in some applications, castellated orifices are formed on the edges of a PCB. In particular, such castellated orifices are manufactured as plated half holes, namely castellated holes. The castellated holes serve as pads to solder a PCB upon a motherboard, with a different soldering method that a solder paste can be applied to the castellated holes on the edges of a PCB. The castellated holes offer good alignment and easy-soldering when mounting a PCB on a motherboard. As the PCBs with different pad forms, such as the LGA pads or the castellated holes, have different layouts and dimensions of the pads and apply different soldering methods, the footprints of the motherboard and the assembling process need to be designed differently.

In possible scenarios, a motherboard may be originally designed to assemble a functionality module implemented with a PCB with castellated holes. If the functionality module needs to be replaced by a different functionality module implemented with a PCB with LGA pads, the motherboard cannot directly assemble the different module. Extra efforts and delay of time will be introduced to modify the footprint and the assembling process.

Such issues are not addressed in the conventional PCB industry.

### SUMMARY OF INVENTION

An object to be achieved is to provide an improved concept for a PCB design with backward compatibility.

This object is achieved with the subject-matter of the independent claims. Embodiments and developments derive from the dependent claims.

According to the present disclosure, a PCB A formed with castellated holes can be mounted on a motherboard. A replacement may occur to dispose a PCB *B* formed with LGA pads instead. The improved concept for a PCB design with backward compatibility is based on the idea that, a PCB C with castellated holes is designed with new spacers on the pad areas, so that the replacement PCB *B* with LGA pads can be correctly overlaid on top of the PCB *C* with the spacers and the PCB *C* is mounted directly on the motherboard in the same way as the PCB *A* is mounted.

By means of the improved concept, a newly designed PCB (e.g. the PCB *C* in the above scenario) formed with castellated holes and applied with new spacers can serve as a mounting adapter. A motherboard originally designed for mounting a PCB with castellated holes can be disposed with a PCB with LGA pads without any change to the motherboard by using the mounting adapter. A module implemented with a PCB with LGA pads can provide backward compatibility by including the newly designed PCB as the mounting adapter.

According to the present disclosure, the newly designed PCB comprises a top surface, a bottom surface, a series of M castellated orifices on at least one of the edges of the PCB, and a series of N conductive pads on the top surface connecting to the M orifices at respective connection edges, wherein M and N are integers greater than 1, and M and N can be the same or different. Each of the pads on the top surface is partially covered by a respective spacer such that an area between the connection edge and a border of a remaining pad area is completely covered by the spacer, and the connection edge and the border of the remaining pad area have a minimum distance of D, wherein D is a positive number in the sense that, the connection edge and the border of the remaining pad area are not overlapping or touching with each other. As such, the spacer occupies a non-empty and continuous area between the connection edge and the border of the remaining pad area. With the spacers partially covering the pads on the top surface of the PCB, when the PCB is used as a mounting adapter between a motherboard and an overlaid PCB, a solder leaking is prevented between the pads on the top surface and the castellated orifices. Therefore, the PCB can be correctly mounted between the motherboard and the overlaid PCB as a mounting adapter.

In some implementations, the spacers are made of a solder mask. The solder mask can stop a solder paste from conductively connecting between the pads and the castellated orifices. In addition or as alternative, the spacers are part of a solder mask covering the top surface of the PCB. In this way, when the top surface is applied with the solder mask, no additional step is needed for forming the spacers.

In some implementations, the castellated orifices are in the form of semi-plated holes, particularly of castellated holes. With castellated holes, the PCB can be easily mounted on a motherboard.

In some implementations, the bottom surface of the PCB comprises N corresponding conductive pads connecting to the M orifices at respective further connection edges. With the N pads on the bottom surface of the PCB, the PCB provides further connectivity between the PCB and a motherboard to be mounted on.

In some implementations, the PCB is a cavity PCB, and the cavity PCB comprises a cavity through the top surface and the bottom surface. With the cavity in the PCB, the PCB provides space for overlaying a second PCB on top, even if the second PCB is disposed with electronic components on the surface towards the cavity of the PCB.

In some further implementations, when the PCB is a cavity PCB according to one of the above implementations, an electronic module comprises the cavity PCB and a second PCB. The second PCB is overlaid on top of the cavity PCB, a bottom surface of the second PCB faces a top surface of the cavity PCB, the bottom surface of the second PCB comprises a series of N conductive pads in land grid array form that are respectively coupled with the N pads on the top surface of the cavity PCB, and the coupled pads are soldered together. With the cavity PCB, the electronic module whose functionality is implemented with the second PCB is provided with backward compatibility, so that the electronic module can be assembled on a motherboard designed for a PCB with castellated orifices without changing the design of the motherboard.

In some further implementations, the coupled pads are soldered together via a solder paste being applied on the remaining pad area of each pad on the top surface of the cavity PCB or on the N pads of the second PCB.

In some implementations, at least one electronic component is disposed on the bottom surface of the second PCB. As such, electronic components can be disposed on one of or both of the top surface and the bottom surface of the second PCB to implement the functionality of the electronic module, so that the electronic module is provided with more flexibility and capacity.

The present disclosure further provides a method for manufacturing a PCB according to the improved concept for a PCB design with backward compatibility. The method comprises providing the PCB with a top surface, a bottom surface, a series of M castellated orifices on at least one of the edges of the PCB, and a series of N conductive pads on the top surface connecting to the M orifices at respective connection edges, wherein M and N are integers greater than 1. The method further comprises partially covering each of the pads on the top surface by a respective spacer such that an area between the connection edge and a border of a remaining pad area is completely covered by the spacer, and the connection edge and the border of the remaining pad area have a minimum distance of D, wherein D is a positive number.

In some implementations of the method, the spacers are made of a solder mask.

In some implementations of the method, the covering each of the pads partially by a respective spacer comprises covering over the top surface of the PCB by a solder mask, wherein the spacers are part of the solder mask.

In some implementations of the method, the PCB is a cavity PCB, and the cavity PCB comprises a cavity through the top surface and the bottom surface.

In some further implementations, when the PCB is a cavity PCB according to one of the above implementations of the method, the method further comprises overlaying a second PCB on top of the cavity PCB, wherein the bottom surface of the second PCB faces the top surface of the cavity PCB, the bottom surface of the second PCB comprises a series of N conductive pads in land grid array form that are respectively coupled with the N pads on the top surface of the cavity PCB, and the coupled pads are soldered together.

In some further implementations, soldering the coupled pads together comprises applying solder paste on the remaining pad area of each pad on the top surface of the cavity PCB or on the N pads of the second PCB.

In some implementations, the method further comprises disposing at least one electronic component on the bottom surface of the second PCB.

Further implementations of the method become readily apparent from the various implementations described above in conjunction with the PCB.

### BRIEF DESCRIPTION OF DRAWINGS

The improved concept for a PCB design with backward compatibility will be explained in more detail in the following with the aid of the drawings.

In the drawings:
- Figure 1: shows an example implementation of a PCB;
- Figure 2: shows an example of details from the implementation of spacers on a PCB;
- Figure 3: shows an example implementation of a spacer;
- Figure 4a, 4b and 4c: show an example electronic module; and
- Figure 5: shows a flowchart of a method for manufacturing a PCB.

### DETAILED DESCRIPTION

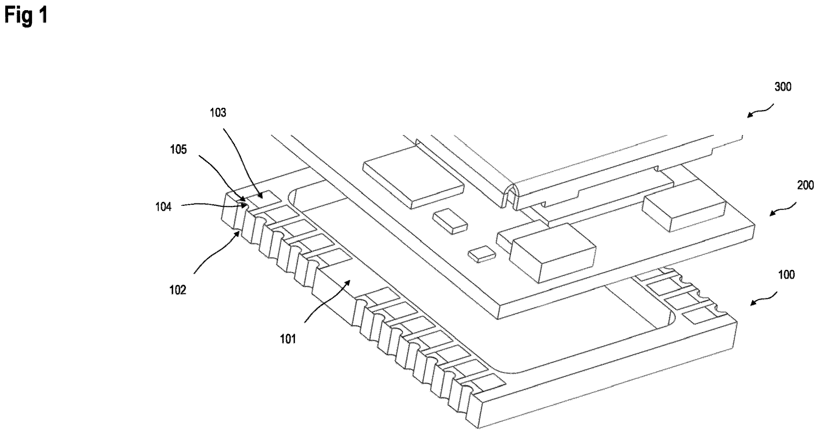

Figure 1 shows an example implementation of a PCB 100. A top surface 101 of PCB 100 is laid upwards, on which an upper PCB 200 may be overlaid. A cover 300 may be further overlaid on the upper PCB 200.

In the example implementation, a series of castellated orifices 102 are formed on two edges of PCB 100. The number of castellated orifices 102 can be an integer greater than 1, and can be formed on one or more edges of PCB 100. As an example, castellated orifices 102 of PCB 100 are castellated holes which are plated half holes.

On the top surface 101 of PCB 100, a series of conductive pads 103 are formed and conductively connected to castellated orifices 102 at respective connection edges 104. In the example implementation, the number of pads 103 and the number of orifices 102 are the same. In this case, each pad 103 is connected to a respective orifice 102 in a one-to-one mapping manner. As a different example implementation, the number of pads 103 and the number of orifices 102 are different. The number of pads 103 may be more than the number of orifices 102. In this case, more than one pad 103 may be connected to a same orifice 102 in a multi-to-one mapping manner. In any case, a connection edge 104 corresponds to the connected edge between a pad 103 and an orifice 102.

On the top surface 101 of PCB 100, each pad 103 is further partially covered by a respective spacer 105.

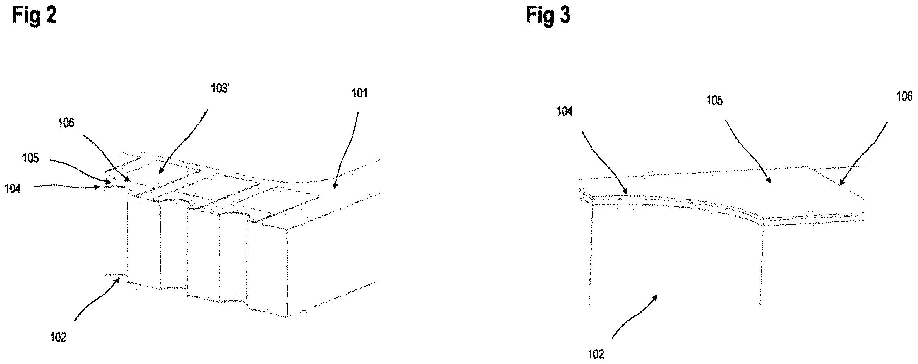

Figure 2 shows an example implementation of spacers 105 on a PCB 100 as shown in Figure 1 according to one of the implementations described above. In the example, each pad 103 is partially covered by a respective spacer 105, and forms a remaining area 103' of each pad 103. A border 106 is one of the borders of the remaining area 103' which is close to the respective orifice 102.

Figure 3 shows an example implementation of a spacer 105 on a pad 103 as shown in Figure 2 according one of the implementations described above. For pad 103, spacer 105 covers completely an area on pad 103 between edge 104 and border 106. Edge 104 and border 106 are not overlapping or touching with each other to ensure that the area covered by spacer 105 is non-empty and continuous. There is a minimal distance between edge 104 and border 106. The minimal distance may be determined based on the requirement of the protection provided by spacer 105. For example, the minimal distance may be determined based on an amount of a solder paste to be applied for soldering pad 103 with another pad, so that the solder paste is stopped by spacer 105 from leaking towards orifice 102 while the amount of the solder paste is sufficient for soldering.

As an example implementation, spacer 105 may be made of a solder mask. For example, spacer 105 may be of epoxy liquid, liquid photoimageable solder mask inks, or dry-film photoimageable solder mask, etc. In addition or as alternative, spacer 105 may be part of a solder mask covering top surface 101 of PCB 100. For example, a complete piece of solder mask may be applied on the whole top surface 101 of PCB 100, and pads 103 are further etched. In this case, only the remaining areas 103' are etched. As a result, spacers 105 are remained on top surface 101 as part of the complete solder mask. Such implementation facilitates the manufacturing process by applying the solder mask on the top surface and applying the spacers in one step.

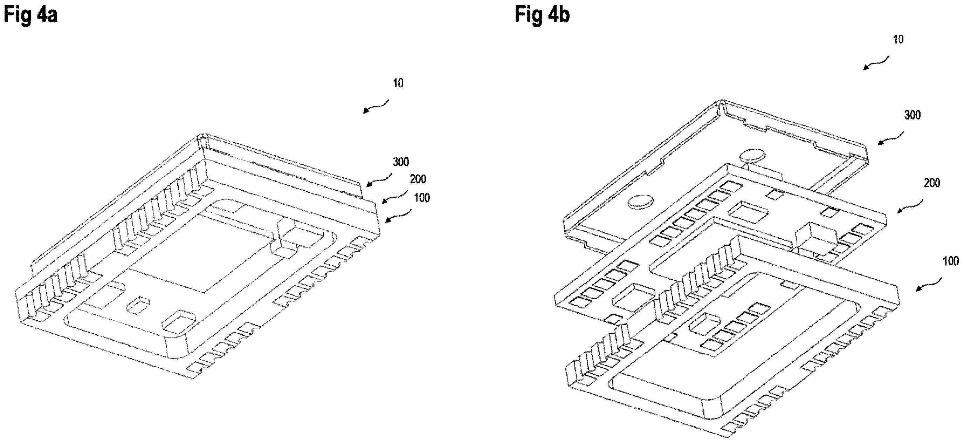

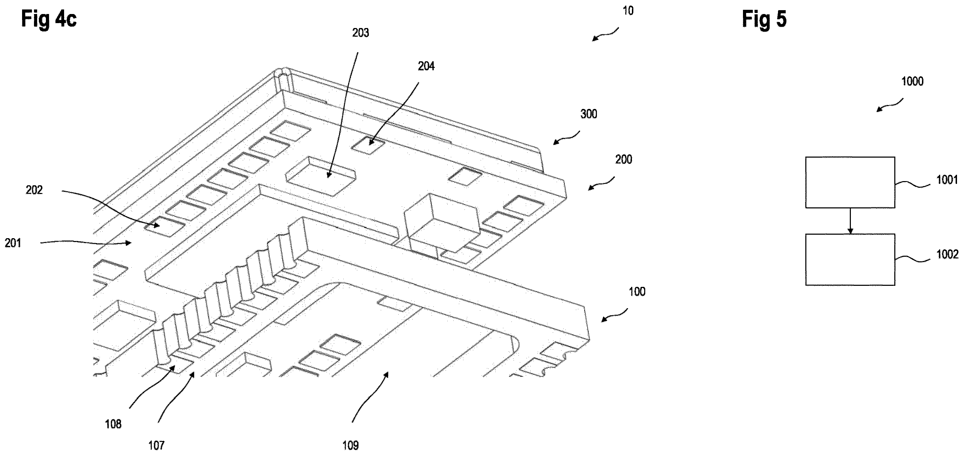

Figure 4a, 4b and 4c show an example electronic module 10 in different views. Module 10 comprises a PCB 100 according one of the implementations described above. PCB 100 is laid on the bottom of module 10. Module 10 further comprises an upper PCB 200 and a cover 300. PCB 200 is laid over PCB 100, and cover 300 is laid over PCB 200.

In the view shown in Figure 4a, module 10 is assembled and can be mounted on a motherboard for further use. In the view shown in Figure 4b, the positioning relationship among PCB 100, PCB 200 and cover 300 inside module 10 is depicted.

For mounting module 10, the castellated orifices on the bottom of the module, i.e. the castellated orifices 102 of PCB 100 will be used for soldering with the pads on the motherboard, so that the module is conductively connected to the motherboard.

In the view shown in Figure 4c, as an example implementation, on the bottom surface 107 of PCB 100, a series of conductive pads 108 are formed on bottom surface 107. Pads 108 are conductively connected to castellated orifices 102 in a same way as pads 103 connected to castellated orifices 102. Hence pads 103 on top surface 101 (not visible in this view) of PCB 100 are further conductively connected to respective pads 108 on bottom surface 107 of PCB 100 via respective castellated orifices 102. In the example implementation, the number of pads 108 and the number of orifices 102 are the same. As a different example implementation, the number of pads 108 and the number of orifices 102 are different. The number of pads 108 may be more than the number of orifices 102.

As an example implementation shown in Figure 4c, PCB 100 comprises a cavity 109. Cavity 109 is a cutout through top surface 101 and bottom surface 107 of PCB 100. Pads 103, castellated orifices 102 and pads 108 are formed around cavity 109. In this case, there is no extra electronic component disposed on PCB 100. PCB 100 provides connectivity between a motherboard and PCB 200.

As a different example implementation, cavity 109 may not be cut through, e.g. only an opening is cutout on top surface 101. In this case, there are remaining layers of PCB 100 which are not cutout, and may be disposed with circuits and electronic components on the remaining layers.

As an example implementation shown in Figure 4c, PCB 200 is laid over PCB 100. Bottom surface 201 of PCB 200 faces to top surface 101 of PCB 100. Bottom surface 201 of PCB 200 comprises a series of conductive pads 202 in LGA form. The number of pads 202 of PCB 200 and the number of pads 103 of PCB 100 are the same, and pads 202 and pads 103 are coupled respectively in pairs and each pair of coupled pads are soldered together.

When soldering each pair of coupled pads, a solder paste is applied. The solder paste may be applied on pad 202, or applied on remaining area 103' of pad 103. In either case, spacer 105 on pad 103 can stop leaking of the solder paste towards orifice 102.

As a different example, the number of pads 202 and the number of pads 103 may be different. In this case, a subset of pads 202 and/or a subset of pads 103 are coupled and soldered together.

As an example implementation, one or more electronic components 203 are disposed on bottom surface 201 of PCB 200. Electronic components 203 may have a maximum size as much as cavity 109 can accommodate. PCB 200 with electronic components 203 may implement certain functionality for module 10.

As an example implementation, bottom surface 201 further comprises one or more glue dots 204, for a reliable physical connection to PCB 100.

Figure 5 shows a flowchart of a method 1000 for manufacturing PCB 100. Method 1000 can be implemented to manufacture the various implementations of PCB 100 described above.

In step 1001 of method 1000, PCB 100 is provided with top surface 101, bottom surface 107, castellated orifices 102, and conductive pads 103. Castellated orifices 102 and conductive pads 103 are connected at respective connection edges 104.

In step 1002 of method 1000, each of pads 103 is partially covered by a respective spacer 105.

In an example implementation of method 1000, in step 1002, spacer 105 is made of a solder mask.

In addition or as an alternative implementation, in step 1002, top surface 101 is overall covered by a solder mask. Remaining areas 103' are etched, and spacers 105 are remained as part of the solder mask.

In an example implementation of method 1000, PCB 100 is formed with a cavity 109, and cavity 109 is cutout through top surface 101 and bottom surface 107.

In a further example implementation of method 1000, PCB 200 in the various implementations described above is overlaid on top of PCB 100. Pads 202 on bottom surface 201 of PCB 200 are in LGA form and respectively coupled with pads 103 on top surface 101 of PCB 100. The coupled pads are soldered together.

In a further example implementation of method 1000, when soldering the coupled pads, a solder paste is applied either on pads 202 or on remaining areas 103' of pads 103.

In an example implementation of method 1000, one or more electronic components are disposed on bottom surface 201 of PCB 200.

Further implementations of method 1000 become readily apparent from the various implementations described above in conjunction with PCB 100 and module 10.

Hence, with the various implementations described above for the improved concept for a PCB design with backward compatibility, a PCB with castellated orifices is provided with spacers to prevent solder leaking. A further PCB with LGA pads can be correctly overlaid on top. When replacing a PCB with castellated orifices with a PCB with LGA pads on a motherboard, the PCB with spacers can be applied as a mounting adapter. The PCB with LGA pads is mounted on the PCB with spacers, and the PCB with spacers is mounted on the motherboard. Therefore, backward compatibility is provided so that the footprint and the mounting process for the motherboard does not need to be adapted with extra efforts and time.

The specification and drawings are, accordingly, to be regarded in an illustrative rather than a restrictive sense. However, it will be evident that various modifications and changes may be made thereunto without departing from the scope of the invention as set forth in the claims.

### LIST OF REFERENCE SIGNS

| | |
|---|---|
| 10 | module |
| 100, 200 | PCB |
| 101-109, 201-204 | parts on PCBs |
| 300 | cover |
| 1000 | method |
| 1001-1002 | steps |

## Claims

1. A printed circuit board (100), PCB, comprising a top surface (101), a bottom surface (107), a series of M castellated orifices (102) on at least one of the edges of the PCB, and a series of N conductive pads (103) on the top surface (101) connecting to the M orifices (102) at respective connection edges (104), M and N being integers greater than 1,
wherein each of the pads (103) on the top surface (101) is partially covered by a respective spacer (105) such that an area between the connection edge (104) and a border (106) of a remaining pad area (103') is completely covered by the spacer (105), and the connection edge (104) and the border (106) of the remaining pad area (103') have a minimum distance of D, D being a positive number.

2. The PCB (100) according to claim 1, wherein the spacers (105) are at least one of:
- made of a solder mask;
- part of a solder mask covering the top surface (101) of the PCB (100).

3. The PCB (100) according to one of claims 1 to 2, wherein the castellated orifices (102) are in the form of semi-plated holes, particularly of castellated holes.

4. The PCB (100) according to one of claims 1 to 3, wherein the bottom surface (107) comprises N corresponding conductive pads (108) connecting to the M orifices (102) at respective further connection edges.

5. The PCB (100) according to one of claims 1 to 4, wherein the PCB (100) is a cavity PCB, and the cavity PCB comprises a cavity (109) through the top surface (101) and the bottom surface (107).

6. An electronic module (10) comprising a first printed circuit board (100), PCB, according to claim 5, and a second PCB (200), wherein the second PCB (200) is overlaid on top of the first PCB (100), a bottom surface (201) of the second PCB (200) faces a top surface (101) of the first PCB (100), the bottom surface (201) of the second PCB (200) comprises a series of N conductive pads (202) in land grid array form that are respectively coupled with the N pads (103) on the top surface (101) of the first PCB (100), and the coupled pads are soldered together.

7. The electronic module (10) according to claim 6, wherein the coupled pads are soldered together via a solder paste being applied on the remaining pad area (103') of each pad (103) on the top surface (101) of the first PCB (100) or on the N pads (202) of the second PCB (200).

8. The electronic module (10) according to one of claims 6 to 7, wherein at least one electronic component (203) is disposed on the bottom surface (201) of the second PCB (200).

9. A method (1000) for manufacturing a printed circuit board, PCB, the method comprising
- providing (1001) the PCB with a top surface, a bottom surface, a series of M castellated orifices on at least one of the edges of the PCB, and a series of N conductive pads on the top surface connecting to the M orifices at respective connection edges, M and N being integers greater than 1, and
- partially covering (1002) each of the pads on the top surface by a respective spacer such that an area between the connection edge and a border of a remaining pad area is completely covered by the spacer, and the connection edge and the border of the remaining pad area have a minimum distance of D, D being a positive number.

10. The method (1000) according to claim 9, wherein the spacers are made of a solder mask.

11. The method (1000) according to one of claims 9 to 10, wherein covering each of the pads partially by a respective spacer comprises: covering over the top surface of the PCB by a solder mask, wherein the spacers are part of the solder mask.

12. The method (1000) according to one of claims 9 to 11, wherein the PCB is a cavity PCB, and the cavity PCB comprises a cavity through the top surface and the bottom surface.

13. The method (1000) according to claim 12, further comprising overlaying a second PCB on top of the cavity PCB, wherein the bottom surface of the second PCB faces the top surface of the cavity PCB, the bottom surface of the second PCB comprises a series of N conductive pads in land grid array form that are respectively coupled with the N pads on the top surface of the cavity PCB, and the coupled pads are soldered together.

14. The method (1000) according to claim 13, wherein soldering the coupled pads together comprises: applying solder paste on the remaining pad area of each pad on the top surface of the cavity PCB or on the N pads of the second PCB.

15. The method (1000) according to one of claims 13 to 14, further comprising disposing at least one electronic component on the bottom surface of the second PCB.
